# EUROPEAN PATENT APPLICATION

(11) **EP 4 597 847 A1**
(43) Date of publication of application: **06.08.2025**
(21) Application number: 25151226.5
(22) Date of filing: 10.01.2025
(51) Int. Cl.: H03L 7/087, H03L 7/091, H03L 7/093, H03L 7/10, H03J 3/20

(54) **LOW PHASE NOISE PHASE LOCKED LOOP**

(71) Applicant: NXP B.V., 5656 AG Eindhoven (NL); University Of Twente, 7522 NB Enschede (NL)
(72) Inventor: Verlinden, Jos, 5656AG Eindhoven (NL); Petricevic, Danilo, 5656AG Eindhoven (NL); Derksen, Sander, 5656AG Eindhoven (NL); Klumperink, Eric, 5656AG Eindhoven (NL)
(74) Representative: Hardingham, Christopher Mark

(57) **Abstract**

An apparatus and method for generating a signal. A signal is generated with an output frequency based on a control signal. A filtered error signal is produced based on a phase difference between a divided frequency of the signal and a frequency reference signal. A time reference signal is generated with a frequency based on a combination of a series connected inductor and capacitor, the signal and the filtered error signal. A filtered time error, indicating a time error between level transitions of the signal based on the output signal and level transitions of a signal based on the time reference signal, is generated with a sample and hold circuit. The control input signal is based on a filtered time error signal.

## Description

### BACKGROUND

### Field

Embodiments of the present invention generally relate to alternating current signal generation, and more particularly relate to alternating current signal generators with low phase noise.

### Related Art

Many radio frequency (RF) systems incorporate signal generators that generate stable waveforms. Such stable waveforms are used, for example, as frequency references, signals that are able to be processed for RF transmission or to base receiver processing of received RF signals, other uses, or combinations of these. Many circuits are able to benefit from signal generators that have low phase noise characteristics.

### BRIEF DESCRIPTION OF THE DRAWINGS

Embodiments of the present invention is illustrated by way of example and is not limited by the accompanying figures, in which like references indicate similar elements. Elements in the figures are illustrated for simplicity and clarity and have not necessarily been drawn to scale.
FIG. 1 illustrates a Phase Locked Loop (PLL) circuit with wideband feedback, according to an example.
FIG. 2 illustrates an example PLL with wideband feedback loop utilizing a sample and hold detector, according to an example.
FIG. 3 illustrates a sample and hold circuit diagram, according to an example.
FIG. 4 illustrates a sample and hold signal waveform graph, according to an example.
FIG. 5 illustrates an example tunable LC time reference circuit, according to an example.
FIG. 6 illustrates a process for generating a signal, according to an example.

### DETAILED DESCRIPTION

The below described systems and methods provide a Phase Locked Loop (PLL) oscillator with reduced phase noise characteristics. The below systems and methods allow realization of improved phase noise performance without incorporating costly process options or expensive discrete components. These systems and methods reduce phase noise characteristics by incorporating a wideband feedback loop around a PLL oscillator to reduce phase noise by including a series Inductor-Capacitor tank circuit (LC-tank) based time reference and a sample and hold time comparator circuit. The LC-tank circuit based time reference circuit has a variable resonant frequency that is adjusted based on a detected phase or frequency error in the Phase Locked Loop circuit. The LC-tank circuit based time reference circuit introduces a particular time delay. At its resonant frequency, the output frequency of the phase locked loop is controlled to maintain that particular time delay.

The below described systems and methods are able to improve phase noise performance by a factor of ten (10). The below described systems and methods operate to decouple the frequency choice of the voltage controlled oscillator (VCO) from the phase noise performance of the circuit. Multipliers and hybrid quadrature couplers are avoided for circuits generating high frequencies, e.g., over twenty Gigahertz (>20 GHz). These systems and methods avoid a requirement for high performance VCOs in cases including multiple VCOs. These systems further provide a reduction of flicker noise (1/f³) and overall system power.

Phase noise of a signal, such as of a frequency reference signal, in the context of the present discussion refers to frequency spectrum components that are near the desired frequency of the particular signal. Phase noise is well understood by practitioners of ordinary skill in the relevant arts and is generally considered to be an undesired component of a signal. In some examples, phase noise of a generated signal is affected by and can be reduced by the characteristics of feedback circuits controlling the operation of one or more oscillators generating that particular signal.

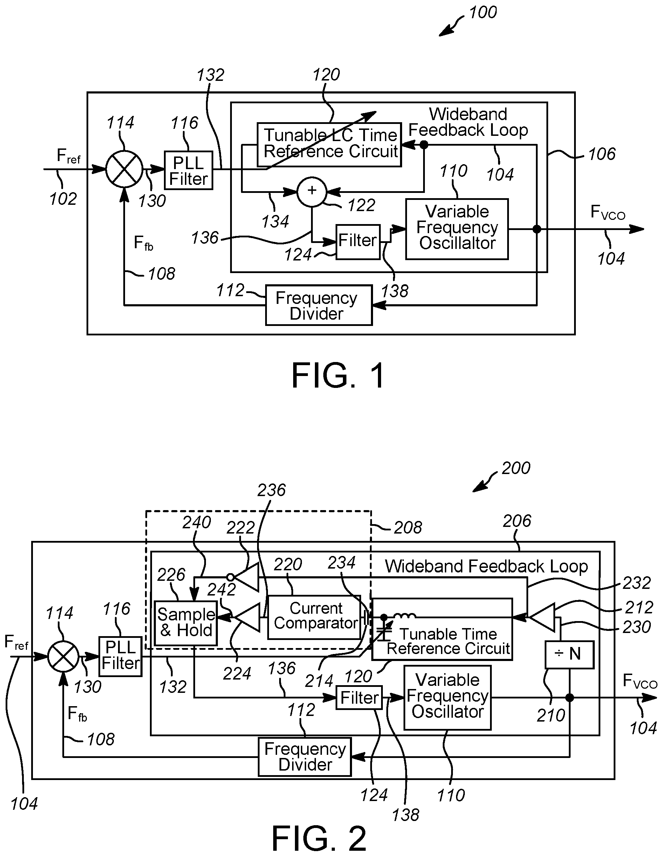

FIG. 1 illustrates a Phase Locked Loop (PLL) circuit with wideband feedback 100, according to an example. The illustrated PLL circuit with wideband feedback 100 depicts a high level block diagram of a PLL oscillator that incorporates a wideband feedback loop 106 with components to enhance its phase noise performance. The illustrated PLL circuit with wideband feedback 100 is an example of a signal generator. In various examples, various PLL architectures are able to be utilized in the implementation of a PLL circuit with wideband feedback 100. In various examples, PLL architectures including analog or digital circuits, integer or fractional frequency division of the feedback signal, designs incorporating techniques such as sub-sampling, injection locking, reference sampling, other techniques, or combinations of these are able to be incorporated in various implementations of a PLL circuit with wideband feedback 100.

The PLL circuit with wideband feedback 100 produces an output signal 104 that has a frequency set by the configuration of the components illustrated for the PLL circuit with wideband feedback 100. The frequency of the output signal 104 in the illustrated example is controlled by a reference frequency (F_{ref}) signal 102. The reference frequency signal 102 is able to be provided by a suitable reference as is familiar to persons of ordinary skill in the relevant arts.

The PLL circuit with wideband feedback 100 includes a variable frequency oscillator circuit 110 that produces the output signal 104 with a frequency that is controlled by a frequency control input signal 138. The variable frequency oscillator circuit 110 is an example of a controlled oscillator circuit and operates to vary the frequency of the output signal 104 based on an input received as a frequency control input signal 138. Processing performed by the components of the PLL circuit with wideband feedback 100 to produce the frequency control input signal 138 is described in further detail below. In various examples, the variable frequency oscillator circuit 110 is able to be implemented as a parallel LC-tank circuit based Voltage Controlled Oscillator (VCO), voltage controlled ring oscillator, current controlled ring oscillator, other designs, or combinations of these.

The output signal 104 produced by the variable frequency oscillator circuit 110 of the PLL circuit with wideband feedback 100 is provided to two feedback loops. The output signal 104 is provided to a frequency divider circuit 112 and to a tunable LC time reference circuit 120. The operation of these two feedback loops is described below.

The frequency divider circuit 112 produces a divided frequency output signal 108 by dividing the frequency of the output signal 104 by a value to produce the divided frequency output signal 108. In the illustrated example, the frequency divider circuit 112 is configured to divide the frequency of the output signal 104 by a value so as to be the same frequency as the frequency of the reference frequency signal 102 to allow comparison of the divided frequency output signal 108 to the reference frequency signal 102 to properly control the frequency of the output signal 104 as is described below. The frequency divider circuit 112 in various examples is configured to divide the frequency of the output signal 104 by a value that is able to include an integer value, a fractional value, in the case of a fractional-N frequency divider circuit, that is able to be a non-integer value less than or greater than one (1), or any number of combinations of these.

The reference frequency signal 102 and the divided frequency output signal 108 are provided to a phase frequency detector circuit 114. The phase frequency detector circuit 114 produces an error signal 130 that indicates a phase or frequency error between the reference frequency signal 102 and the divided frequency output signal 108. In an example, the error signal 130 is able have a magnitude of, for example, a voltage, current, digital data, other indicator, or combinations of these, to indicate the phase or frequency difference between the reference frequency signal 102 and the divided frequency output signal 108.

The error signal 130 is filtered by a Phase Locked Loop (PLL) filter circuit 116 to produce a filtered error signal 132. In general, the PLL filter circuit 116 is a low pass filter to condition the divided frequency output signal 108 to produce a filtered error signal 132 with time response characteristics suitable to properly control the frequency of the output signal 104 according to various design criteria.

A tunable LC time reference circuit 120 operates to produce a time reference signal 134. The tunable LC time reference circuit 120 receives the output signal 104. The output signal 104 drives a series LC-tank circuit within the tunable LC time reference circuit 120 to produce a time reference signal 134. The operation of the tunable LC time reference circuit 120 delays the time reference signal 134 based on a combination of a frequency of the output signal 104 and values of a series connected inductor and capacitor in the series LC-tank circuit. In an example, a value of one or more components in the series LC-tank circuit within the tunable LC time reference circuit 120, and thus the resonant frequency of the series LC-tank circuit, is varied based on the low pass filtered error signal 132. Examples of a tunable LC time reference circuit 120 is described below. In an example, the series LC-tank circuit within the tunable LC time reference circuit 120 introduces a defined time delay, which in an example is a ninety degree (90°) phase shift of the output signal 104 at the resonant frequency series LC-tank circuit, and introduces other phase shifts at frequencies different from the resonant frequency of the series LC-tank circuit.

The time reference signal 134 and the output signal 104 are provided to a time error detector circuit 122. The time error detector circuit 122 determines a time error signal 136 between the time reference signal 134 and the output signal 104. The time error signal 136 is filtered by an oscillator filter 124 to produce the frequency control input signal 138 that controls the frequency of the output signal 104 produced by the variable frequency oscillator circuit 110.

FIG. 2 illustrates an example PLL with wideband feedback loop utilizing a sample and hold detector 200, according to an example. The example PLL with wideband feedback loop utilizing a sample and hold detector 200 illustrates an example of a circuit to realize a version of the above described PLL circuit with wideband feedback 100. The example PLL with wideband feedback loop utilizing a sample and hold detector 200 includes an example wideband feedback loop 206 that has an example time error detector circuit 208 that includes a sample and hold circuit 226 as is described below.

The example PLL with wideband feedback loop utilizing a sample and hold detector 200 includes the above described elements of the PLL circuit with wideband feedback 100. In particular, elements including the above described variable frequency oscillator circuit 110, frequency divider circuit 112, phase frequency detector circuit 114, and PLL filter circuit 116 operate as described above and produce their respective signals as is also described above. The example PLL with wideband feedback loop utilizing a sample and hold detector 200 includes an example wideband feedback loop 206 that is an example of an implementation of the above described wideband feedback loop 106 with an example time error detector circuit 208 that includes a sample and hold circuit. The elements of the example wideband feedback loop 206 and their operation is described below. As described below, the example wideband feedback loop 206 includes components to support the operation of the example time error detector circuit 208.

The example wideband feedback loop 206 includes a divide-by-N (÷ N) circuit 210 that receives the output signal 104 and operates to divide the frequency of the output signal 104 by a number "N." The frequency of the output signal 104 in an example is divided by the divide-by-N circuit 210 in order to allow elements of the example wideband feedback loop 206, such as the tunable LC time reference circuit 120, to be designed to operate and thus be optimized for frequencies that differ from the frequency of the output signal 104. In various examples, N is able to be an integer or a fractional number by which the frequency of the output signal 104 is divided. The divide-by-N circuit 210 produces a feedback signal 230 that consists of a signal with a frequency equal to the frequency of the output signal 104 divided by "N." When dividing the frequency of the output signal 104 by a fractional, i.e., non-integer, number, the divide-by-N circuit 210 is referred to as a fractional-N frequency divider circuit. The feedback signal 230 is an example of a signal based on the output signal 104 and thus comprises a signal based on the output signal 104.

The feedback signal 230 is amplified by a feedback amplifier 212 to condition the feedback signal 230 and produce an amplified feedback signal 232 as an input into the tunable LC time reference circuit 120. The amplified feedback signal 232 is a further example of a signal based on the output signal 104, and thus comprises a signal based on the output signal 104. An example of a tunable LC time reference circuit 120 is described below with regards to the example tunable LC time reference circuit 500 described in further detail below.

The tunable LC time reference circuit 120 produces a time reference signal 234 with a frequency based on a combination of a series connected inductor and capacitor, the output signal 104, and the low pass filtered error signal 132. An example of a circuit to control the frequency of the time reference signal 234 by the low pass filtered error signal 132 is described below. In the illustrated example, the tunable LC time reference circuit 120 produces a time reference signal 234 that has a ninety degree (90°) phase shift from its input, i.e., the amplified feedback signal 232.

The time reference signal 234 is provided to a time error capacitor 214 in series with a current comparator circuit 220. The current comparator circuit 220 compares the present electrical current value of its input, based on time reference signal 234 being converted into an electrical current by time error capacitor 214, to an electrical current threshold. In some examples, the electrical current threshold is zero (0) but other values are able to be used. The time error capacitor 214 and current comparator circuit 220 introduces another ninety degree (90°) phase shift in addition to the ninety degree (90°) phase shift introduced by the tunable LC time reference circuit 120 and produces a buffered time reference signal 236 with the frequency of the time reference signal 234 that is offset by one hundred and eighty degrees (180°) from the amplified feedback signal 232. The current comparator circuit 220, in some examples, produces a square wave as the buffered time reference signal 236.

The buffered time reference signal 236 is amplified by a time reference amplifier circuit 224 to produce an amplified time reference signal 242. In an example, the time reference amplifier circuit 224 is a hard limiting amplifier that produces an amplified time reference signal 242 that varies between two levels. In some examples the time reference amplifier circuit 224 has a finite slew rate when transitioning, at the frequency of the amplified time reference signal 242, between those levels as is described in further detail below. In various examples, the combination of the time error capacitor 214, current comparator circuit 220, and the time reference amplifier circuit 224 operate to produce a buffered time reference signal 242 that has a finite slew rate in accordance with the description below. The amplified time reference signal 242 is provided to a first input of a sample and hold circuit 226.

Returning to the amplified feedback signal 232, the amplified feedback signal 232 is amplified by an inverting feedback signal amplifier circuit 222 to produce an inverted feedback signal 240, which is an inversion of the amplified feedback signal 232. In an example, the inverting feedback signal amplifier circuit 222 is an example of an inverter circuit that operates as a hard limiting amplifier to produce an inverted feedback signal 240 that is a two level signal that is thus offset by one hundred and eighty degrees (180°) from the amplified feedback signal 232 with a 50% duty cycle. This one hundred and eighty degree (180°) phase shift matches the phase shift of the amplified time reference signal 242 relative to the amplified feedback signal 232. The inverted feedback signal 240 is provided as a second input to the sample and hold circuit 226.

An example implementation sample and hold circuit 226 and its operation are described in further detail below. The sample and hold circuit 226 operates to capture the value of the amplified time reference signal 242 when the inverted feedback signal 240 transitions across a threshold level. The output of the sample and hold circuit 226 is produced as a time error signal 136. As described in further detail below, the value of the time error signal 136 is proportional to a time difference between the inverted feedback signal 240 and the amplified time reference signal 242. The time difference can be caused by a variation of the frequency of the output signal 104 compared to the resonance frequency of the series-LC tank in the tunable time reference circuit 120. In an example, the amplified time reference signal 242 has a finite slew rate and the value of the amplified time reference signal 242 when the inverted feedback signal 240 transitions a threshold of the sample and hold circuit 226 is captured and produced as the time error signal 136. The time error signal 136 is provided to the oscillator filter 124 to control the frequency of the variable frequency oscillator circuit 110 as is described above with regards to the above described PLL circuit with wideband feedback 100.

The above described PLL with wideband feedback loop utilizing a sample and hold detector 200 is one example of a PLL circuit with wideband feedback 100. Further variations of the above described PLL circuit with wideband feedback 100 are able to be realized based on variations of the PLL with wideband feedback loop utilizing a sample and hold detector 200. For example, alternative designs are able to combine the sample and hold circuit 226 and oscillator filter 124 into a single circuit structure. In some examples, the tunable LC time reference circuit 120, the wideband feedback loop 206, or combinations of these, are able to be realized as either a differential structure or a single-ended circuit structure. The oscillator filter 124 in various examples is able to be realized by any suitable structure such as active or passive circuits, proportional control operations, integrating control operations, or any combinations of these.

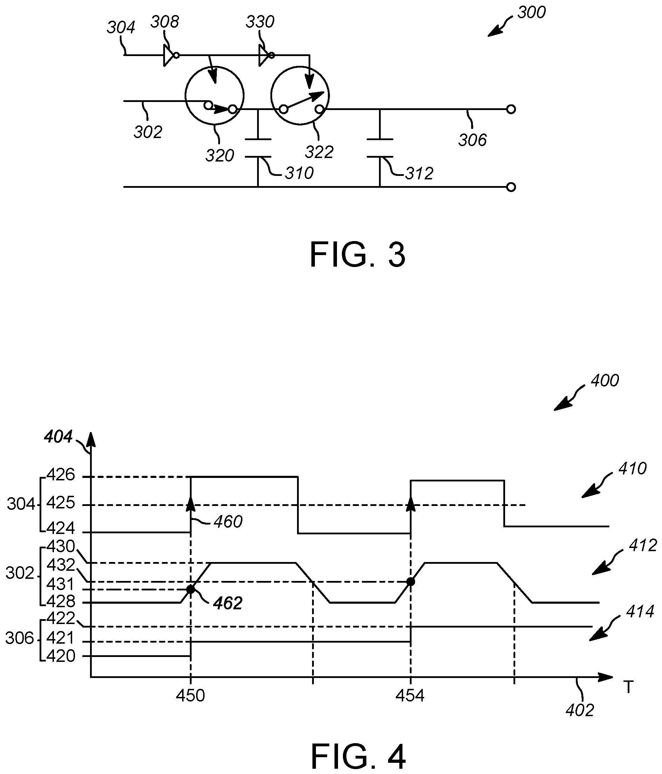

FIG. 3 illustrates a sample and hold circuit diagram 300, according to an example. The sample and hold circuit diagram 300 depicts a simplified example of components of the above described sample and hold circuit 226.

The sample and hold circuit diagram 300 depicts a signal input 302 and a sample control input 304. A control signal provided to the sample control input 304 controls the operation of the circuits of the sample and hold circuit diagram 300. When the sample control input 304 is asserted, the signal level at the signal input 302 is sampled. When the sample control input 304 is de-asserted, the level sampled at the signal input 302 is held as a sample and hold output signal 306.

The components depicted for the sample and hold circuit diagram 300 include a sample switch 320, a sample capacitor 310, a hold switch 322, and a hold capacitor 312. A voltage held on the hold capacitor 312 is provided as a sample and hold output signal 306.

The sample switch 320 and the hold switch 322 are controlled by a signal level of the sample control input 304. In the illustrated example, the sample switch 320 or the hold switch 322 are open when their control input is low, and are closed when their control input is high. The signal on the sample control input 304 is inverted by control inverter 308 whose output is provided to an inverter 330. The operation of the inverter 330 causes the sample switch 320 and the hold switch to be in opposite states.

When the sample control input 304 transitions from a low level or state to a high level or state, the control inverter 308 inverts that signal and the sample switch 320 is open and the hold switch 322 is closed thus isolating the sample capacitor 310 from the signal input 302 and connecting the sample capacitor 310 to the hold capacitor 312 and to the sample and hold output signal 306. This causes the hold capacitor 312 to be charged to the voltage present on the sample capacitor 310, which is the voltage present at the signal input 302 at the time of this transition. The time of this transition is the time at which the voltage of the signal input 302 is sampled and is thus maintained at the sample and hold output signal 306.

When the sample control input 304 transitions from a high level or state to a low level or state, the output of the control inverter 308 causes sample switch 320 to close, the hold switch 322 to open and thus connects the sample capacitor 310 to the signal input 302. This is the illustrated configuration of the sample switch 320 and the hold switch 322. While the hold switch is open, the sample capacitor 310 is isolated from the hold capacitor 312 and the hold capacitor 312 is connected to the output signal 306. This causes the sample capacitor 310 to be charged to the voltage of the signal input 302 and the output signal is held at the voltage present on the sample capacitor when the sample control input 304 last transitioned from a low level to a high level.

FIG. 4 illustrates a sample and hold signal waveform graph 400, according to an example. The sample and hold signal waveform graph 400 depicts signal levels of signals described above as inputs and outputs of the sample and hold circuit diagram 300. The sample and hold signal waveform graph 400 depicts signal levels present at the ports of the above described sample and hold circuit

The sample and hold signal waveform graph 400 depicts a sample control input level vs. time waveform 410 that is an example of a waveform of the sample control input 304. A depicted input level vs. time waveform 412 is an example of the signal input 302. A depicted output level vs. time waveform 414 is an example of a sample and hold output signal 306 and is based on the input level vs. time waveform 410 and the sample control input level vs. time waveform 412 being provided as the inverted feedback signal 240 and the amplified time reference signal 242 inputs, respectively, to the sample and hold circuit 226 described above.

The sample control input level vs. time waveform 410, which corresponds to the inverted feedback signal 240 that is based on the output by the divide-by-N circuit 210 and amplified by the feedback amplifier 212 and inverting feedback signal amplifier circuit 222, has a generally square wave shape. The depicted input level vs. time waveform 412, which in an example corresponds to the above described amplified time reference signal 242 as provided by the processing performed on the amplified feedback signal 232 by the tunable time reference circuit 120, the time error capacitor 214, current comparator circuit 220, and time reference amplifier circuit 224. The operation of these circuits causes the input level vs. time waveform 412 to have a slower slew rate than is present on the sample control input level vs. time waveform 410.

The sample control input level vs. time waveform 410 shows an occurrence of a first level transition 460 at a first level transition time 450, which is an example of a time of a level transition. The first level transition time 450 is a time at which the sample control input level vs. time waveform 410 transitions from a sample input low level 424 across a threshold level 425 to a sample input high level 426. The input level vs. time waveform 412 is able to have a level between a minimum input level 428 and a maximum input level 430 during transitions due to its finite slew rate. The first level transition 460 causes the sample and hold circuit 226 to sample the value of the input level vs. time waveform 412 that exists at the first level transition time 450, i.e., the value of the first input sample level 431 that exists as indicated by the first sample point 462 in the illustrated example. The slew rate of the input level vs. time waveform 412 is finite but is generally repeatable over a several cycles. The values of the input level vs. time waveform 412 that occur at the times of a series of occurrences of level transitions of the sample control input level vs. time waveform 410 thus reflect the time of occurrence of the level transitions of the input level vs. time waveform 412. The output level vs. time waveform 414 thus also transitions to the first output level 421 at the first level transition time 450, a level that corresponds to the first input sample level 431 of the input level vs. time waveform 412 at that time.

The output level vs. time waveform 414 maintains the first output level 421 until a second occurrence of a level transition of the sample control input level vs. time waveform 410 from the sample input low level 424 through the threshold level 425 to the sample input high level 426 at a second sample transition time 454. In the illustrated example, the input level vs. time waveform 412 is at a second input sample level 432 at the second sample transition time 454. This relationship where the second input sample level 432 is higher than the first input sample level 431 at the second occurrence of the level transition indicates that the frequency of the input level vs. time waveform 412 was higher than the frequency of the sample control input level vs. time waveform 410 at the first level transition 460. In the illustrated example, the first input sample level 431 is too low and thus indicates a too high frequency with respect to the resonance frequency of the series-LC tank. The second input sample level 432 is higher than the first input sample level 431 and thus indicates a decreasing time difference, or error, which at the second sample transition time 454 is zero indicating that the frequency is correct. Accordingly, the output level vs. time waveform 414 transitions to a second output level 422, which corresponds to the second input sample level 432. The second output level 422 is therefore also higher than the first output level 421. This higher level will correspond to an increase of the value of the time error signal 136 being produced by the sample and hold circuit 226 to drive the oscillator filter 124 and thus produce the frequency control input signal 138 reducing the frequency of the output signal 104 produced by the variable frequency oscillator circuit 110. This operation is an example of determining the time error based on a time difference between an occurrence of the level transition of the signal based on the output signal and a level transition of a signal based on the time reference signal.

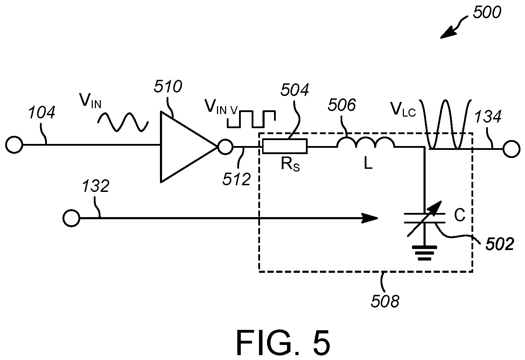

FIG. 5 illustrates an example tunable LC time reference circuit 500, according to an example. The example tunable LC time reference circuit 500 depicts an example circuit to implement the above described tunable LC time reference circuit 120. The example tunable LC time reference circuit 500 forms a series LC-tank circuit that is driven by the above described output signal 104 and produces the time reference signal 134 that is delayed based on the frequency of the output signal 104. In further examples, the LC-tank circuit is driven by a signal derived from the output signal 104, such as a signal with a frequency equal to the frequency of the output signal 104 divided by a value that is a constant in an example.

The illustrated example tunable LC time reference circuit 500 includes an inductor 506, a series resistor 504 that represents the parasitic resistance of the inductor 506, and variable capacitor 502 that are arranged in a series circuit 508. The series circuit 508 includes a series connected indictor and capacitor. This components in the series circuit 508 are selected so as to have a desired resonant frequency that corresponds to a desired frequency of time reference signal 134.

The series circuit 508 is driven by an inverting amplifier circuit 510. The inverting amplifier circuit 510 in the illustrated example is a hard limiting amplifier that produces a square wave at its amplifier output 512. In general, the configuration of the series circuit 508 and the inverting amplifier circuit 510 produces an essentially square wave voltage (V_{IN V}) across the series circuit 508 and the operation of the series circuit 508 results in a sinusoidal electrical current flowing through the series circuit 508 and thus producing a sinusoidal voltage (V_{LC}) across the variable capacitor 502. The voltage across the variable capacitor 502 is the output of the tunable LC time reference circuit 500 and is produced as the time reference signal 134. In further examples, the LC-tank circuit is driven by a signal derived from the output signal 104, such as a signal with a frequency equal to the frequency of the output signal 104 divided by a value that is able to be a constant. It is clear that the frequency of the output signal 104, or other signal driving the LC-tank circuit, is a basis for the frequency of the time reference signal 134.

The illustrated example tunable LC time reference circuit 500 has a variable capacitor 502 that has a capacitance value controlled by the above described filtered error signal 132. In an example, the variable capacitor is able to be a variable reactor, known as a varactor, that has a capacitance value based on the voltage across its terminals. In such an example, circuitry (not shown) produces a voltage across the variable capacitor 502 that is proportional to the filtered error signal 132. The filtered error signal 132 controls the value of the variable capacitor 502 and thus varies the frequency of the time reference signal 134. The filtered error signal 132 is thus part of a basis for the frequency of the time reference signal 134.

The illustrated example tunable LC time reference circuit 500 uses a series arrangement of indictive (L) components, such as inductor 506, and capacitive (C) components, such as variable capacitor 502, to form a series LC-tank circuit. It has been found that incorporation of a tunable LC time reference circuit that uses such a series LC-tank circuit connection into the feedback loop of the PLL with wideband feedback 100 described above provides improved phase noise performance relative to using a tunable LC time reference circuit 120 that connects indictive components and capacitive components in a parallel configuration.

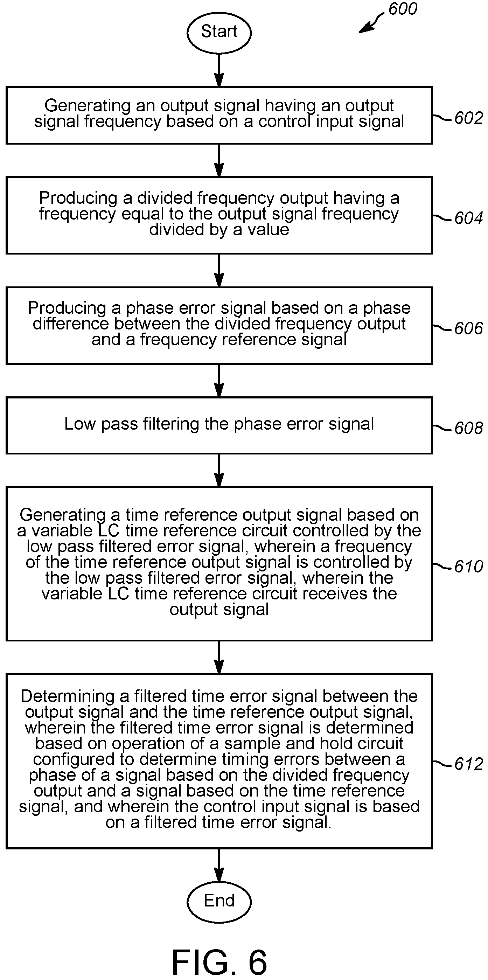

FIG. 6 illustrates a process for generating a signal 600, according to an example. The process for generating a signal 600 is a process performed by a PLL circuit with wideband feedback 100 such as the sample and hold circuit diagram 300 described above.

The process for generating a signal 600 generates, at 602, an output signal having an output signal frequency based on a control input signal. The output signal in an example is generated by the variable frequency oscillator circuit 110 described above.

A divided frequency output having a frequency equal to the output signal frequency divided by a value is generated, at 604. The divided frequency output in an example is generated by the frequency divider circuit 112 described above. In some examples, the value by which the output signal frequency is divided is able to be a constant.

A phase error signal is produced, at 606, based on a phase difference between the divided frequency output and a frequency reference signal. The phase error signal in an example is produced by the phase frequency detector circuit 114 described above.

The phase error signal is low pass filtered, at 608. Low pass filtering of the phase error signal in an example is performed by the PLL filter circuit 116 described above.

A time reference signal is generated, at 610, based on a tunable LC time reference circuit controlled by the low pass filtered error signal. The frequency of the time reference signal is controlled by the low pass filtered error signal and the tunable LC time reference circuit receives the output signal.

A filtered time error signal indicating time differences is determined, at 612. The filtered time error signal is determined based on operation of a sample and hold circuit configured to determine timing errors between a level transitions of a signal based on the divided frequency output and a signal based on the time reference signal. The control input signal, discussed above with regards to generating, at 602, an output signal having an output signal frequency based on a control input signal, is based on this filtered time error signal. The process for generating a signal 600 then ends.

In an example, a signal generator 100 includes a controlled oscillator circuit 110 configured to generate an output signal 104 having an output signal frequency based on a control input signal 138. The signal generator further includes a frequency divider circuit 112 configured to produce a divided frequency output 108 having a frequency equal to the output signal frequency divided by a value, a phase frequency detector circuit 114 configured to produce a phase error signal 130 based on a phase difference between the divided frequency output and a frequency reference signal 102, and a Phase Locked Loop (PLL) filter circuit 116 configured to generate a low pass filtered error signal 132 with a frequency based on low pass filtering the phase error signal. The signal generator also includes a tunable LC time reference circuit 120, 500 configured to generate a time reference signal 134 with a frequency based on a combination of a series connected inductor 506 and capacitor 502, a signal based on the output signal 232, and the low pass filtered error signal. The signal generator further includes a time error detector circuit 208 configured to determine a filtered time error signal 236 indicating a time error between a level transition of a signal based on the output signal 410 and a level transition of the time reference signal 412, wherein the time error detector circuit comprises a sample and hold circuit 226, 300 configured to determine the time error based on a time difference between an occurrence of the level transition of the signal based on the output signal 460 and the level transition of a signal based on the time reference signal 462. The control input signal of the signal generator is based on a filtered time error signal 138.

In another example, a method of generating a signal includes generating an 602 output signal 104 having an output signal frequency based on a control input signal 138, producing 604 a divided frequency output 108 having a frequency equal to the output signal frequency divided by a value, and producing 606 a phase error signal 130 based on a phase difference between the divided frequency output and a frequency reference signal 102. The method also includes low pass filtering the phase error signal 608 to produce a filtered error signal 132. The method further includes generating 610 a time reference signal 134 based on a tunable LC time reference circuit 120, 500 comprising a series connected inductor 506 and capacitor 502, wherein a frequency of the time reference signal is based on a combination of a series connected inductor and capacitor, the output signal, and the low pass filtered error signal. The method includes determining 612 a filtered time error signal 236 indicating a time error between a level transition of a signal based on the output signal 460 and a level transition of the time reference signal 462, wherein the filtered time error signal is determined based on operation of a sample and hold circuit 226, 300 configured to determine the time error based on a time difference between a level transition of the signal based on the output signal and the level transition of the time reference signal. The control input signal is based on a filtered time error signal.

The term "coupled", as used herein, is defined as "connected" and encompasses the coupling of devices that may be physically, electrically or communicatively connected, although the coupling may not necessarily be directly and not necessarily be mechanical. The term "configured to" describes hardware, software, or a combination of hardware and software that is adapted to, set up, arranged, built, composed, constructed, designed, or that has any combination of these characteristics to carry out a given function. The term "adapted to" describes hardware, software, or a combination of hardware and software that is capable of, able to accommodate, to make, or that is suitable to carry out a given function.

The terms "a" or "an", as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to invention embodiments containing only one such element, even when the same claim includes the introductory phrases "one or more" or "at least one" and indefinite articles such as "a" or "an". The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The term "coupled", as used herein, is not intended to be limited to a direct coupling or a mechanical coupling, and that one or more additional elements may be interposed between two elements that are coupled.

As will be appreciated by one skilled in the art, aspects of the present disclosure may be embodied as a system, method, or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "circuit" or "system".

The one or more embodiments of the invention may be a system, a method, and/or a computer program product. The computer program product may include a computer-readable storage medium (or media) having computer readable program instructions thereon for causing a processor to carry out aspects of the inventive embodiments.

In one embodiment, the computer program product includes a non-transitory storage medium readable by a processing circuit and storing instructions for execution by the processing circuit for performing a method. The computer-readable storage medium can be a tangible device that can retain and store instructions for use by an instruction execution device. The computer-readable storage medium may be, for example, but is not limited to, an electronic storage device, a magnetic storage device, an optical storage device, an electromagnetic storage device, a semiconductor storage device, or any suitable combination of the foregoing. A computer-readable storage medium, as used herein, is not to be construed as being transitory signals per se, such as radio waves or other freely propagating electromagnetic waves, electromagnetic waves propagating through a waveguide or other transmission media, e.g., light pulses passing through a fiber-optic cable), or electrical signals transmitted through a wire.

Computer-readable program instructions for carrying out operations of the inventive embodiments may be assembler instructions, instruction-set-architecture (ISA) instructions, machine instructions, machine-dependent instructions, microcode, firmware instructions, state-setting data, or either source code or object code written in any combination of one or more programming languages, including an object-oriented programming language such as Smalltalk, C++, and conventional procedural programming languages, such as the "C" programming language or similar programming languages. The computer-readable program instructions may execute entirely or partly on a user's computer or entirely or partly on a remote computer or server. In the latter scenario, the remote computer may be connected to the user's computer through any type of network, including a local area network (LAN), a wide area network (WAN), an Ultra-Wide Band (UWB) network, or the connection may be made to an external computer (for example, through the Internet). In some embodiments, electronic circuitry including, for example, programmable logic circuitry, field-programmable gate arrays (FPGA), or programmable logic arrays (PLA) may execute the computer-readable program instructions by utilizing state information of the computer-readable program instructions to personalize the electronic circuitry, in order to perform aspects of the inventive embodiments.

Aspects of one or more embodiments of the invention are described herein with reference to flowchart illustrations and/or block diagrams of methods, apparatus (systems), and computer program products according to embodiments of the invention. Each block of the flowchart illustrations and/or block diagrams, and combinations of blocks in the flowchart illustrations and/or block diagrams, can be implemented by computer readable program instructions.

These computer-readable program instructions may be provided to a processor of a general-purpose computer, special purpose computer, or other programmable data processing apparatus to produce a machine, such that the instructions, which execute via the processor of the computer, create means for implementing the functions/acts specified in the flowchart and/or block diagram blocks. These computer-readable program instructions may also be stored in a computer-readable storage medium that can direct a computer to function in a particular manner, such that the computer-readable storage medium having instructions stored therein comprises an article of manufacture including instructions which implement aspects of the function/act specified in the flowchart and/or block diagram block or blocks.

The description of the present disclosure has been presented for purposes of illustration and description but is not intended to be exhaustive or limited to the inventive embodiments in the form disclosed. Many modifications and variations will be apparent to those of ordinary skill in the art without departing from the scope and spirit of the inventive embodiments. One or more embodiments were chosen and described in order to best explain the principles of the inventive subject matter and the practical application and to enable others of ordinary skill in the art to understand the inventive subject matter for various embodiments with various modifications as are suited to the particular use contemplated.

Although specific embodiments of the invention have been disclosed, those having ordinary skill in the art will understand that changes can be made to the specific embodiments without departing from the spirit and scope of the inventive embodiments. The scope of the inventive subject matter is not to be restricted, therefore, to the specific embodiments, and it is intended that the appended claims cover any and all such applications, modifications, and embodiments within the scope of the inventive subject matter.

## Claims

1. A signal generator, comprising:
a controlled oscillator circuit configured to generate an output signal having an output signal frequency based on a control input signal;
a frequency divider circuit configured to produce a divided frequency output having a frequency equal to the output signal frequency divided by a value;
a phase frequency detector circuit configured to produce a phase error signal based on a phase difference between the divided frequency output and a frequency reference signal;
a Phase Locked Loop (PLL) filter circuit configured to generate a low pass filtered error signal with a frequency based on low pass filtering the phase error signal;
a tunable LC time reference circuit configured to generate a time reference signal with a frequency based on a combination of a series connected inductor and capacitor, a signal based on the output signal, and the low pass filtered error signal; and
a time error detector circuit configured to determine a filtered time error signal indicating a time error between a level transition of a signal based on the output signal and a level transition of the time reference signal,
wherein the time error detector circuit comprises a sample and hold circuit configured to determine the time error based on a time difference between an occurrence of the level transition of the signal based on the output signal and the level transition of a signal based on the time reference signal, and
wherein the control input signal is based on a filtered time error signal.

2. The signal generator of claim 1, where the series connected inductor and capacitor comprise a variable capacitor with a capacitance value controlled by the low pass filtered error signal.

3. The signal generator of claim 1, further comprising:
a divide-by-N circuit configured to receive the output signal and produce a feedback signal comprising the signal based on the output signal, where the feedback signal has a frequency equal to the output signal frequency divided by a value, and
wherein the time error detector circuit comprises:
a current comparator circuit configured to receive the time reference signal and produce a buffered time reference signal based on a comparison of an electrical current value of the time reference signal to an electrical current threshold; and
a time comparator circuit configured to determine a time error signal based on a time difference between a time of occurrence of the level transition of the signal based on the output signal and of a level transition of a signal based on the time reference signal, wherein the filtered time error signal is based on the time error signal.

4. The signal generator of claim 3, wherein the buffered time reference signal has a finite slew rate.

5. The signal generator of claim 3, wherein the tunable LC time reference circuit induces a ninety degree (90°) phase shift between the output signal and the time reference signal, and
wherein the time error detector circuit further comprises:
a time error capacitor configured to receive the time reference signal and couple the tunable LC time reference circuit to a current comparator circuit; and
an inverter circuit configured to invert the feedback signal and provide an inverted feedback signal to the time comparator circuit.

6. The signal generator of claim 3, where the divide-by-N circuit comprises a fractional-N frequency divider circuit.

7. A method of generating a signal, comprising:
generating an output signal having an output signal frequency based on a control input signal;
producing a divided frequency output having a frequency equal to the output signal frequency divided by a value;
producing a phase error signal based on a phase difference between the divided frequency output and a frequency reference signal;
low pass filtering the phase error signal to produce a filtered error signal;
generating a time reference signal based on a tunable LC time reference circuit comprising a series connected inductor and capacitor, wherein a frequency of the time reference signal is based on a combination of a series connected inductor and capacitor, the output signal, and the low pass filtered error signal; and
determining a filtered time error signal indicating a time error between a level transition of a signal based on the output signal and a level transition of the time reference signal,
wherein the filtered time error signal is determined based on operation of a sample and hold circuit configured to determine the time error based on a time difference between a level transition of the signal based on the output signal and the level transition of the time reference signal, and
wherein the control input signal is based on a filtered time error signal.

8. The method of claim 7, where the series connected inductor and capacitor comprise a variable capacitor with a capacitance value controlled by the low pass filtered error signal.

9. The method of claim 7, further comprising:
receiving the output signal and producing a feedback signal, where the feedback signal has a frequency equal to the output signal frequency divided by a value, and
producing a buffered time reference signal based on a comparison of an electrical current value of the time reference signal to an electrical current threshold; and
determining a time error signal based on a time difference between a time of occurrence of the level transition of the signal based on the output signal and of a level transition of a signal based on the time reference signal, wherein the filtered time error signal is based on the time error signal.

10. The method of claim 9, wherein the tunable LC time reference circuit induces a ninety degree (90°) phase shift between the output signal and the time reference signal,
wherein determining a filtered time error signal is based on an inversion of the feedback signal, and
wherein the method further comprises coupling the time reference signal to a current comparator circuit via a time error capacitor.

11. The method of claim 9, wherein producing the feedback signal comprises processing the output signal with a fractional-N frequency divider circuit.
